# EUROPÄISCHE PATENTSCHRIFT

(11) **EP 3 594 044 B1**
(45) Veröffentlichungstag und Bekanntmachung des Hinweises auf die Patenterteilung: **01.09.2021**
(21) Anmeldenummer: 19184508.0
(22) Anmeldetag: 04.07.2019
(51) Int. Cl.: G06F 3/044, G06F 3/0362, H03K 17/96, B60K 37/06

(54) **KAPAZITIVES KRAFTFAHRZEUGBEDIENSYSTEM**
CAPACITIVE MOTOR VEHICLE CONTROL SYSTEM
SYSTÈME CAPACITIF DE COMMANDE DE VÉHICULE AUTOMOBILE

(30) Priorität: 11.07.2018 DE 102018116833
(43) Veröffentlichungstag der Anmeldung: 15.01.2020
(73) Patentinhaber: BCS Automotive Interface Solutions GmbH, 78315 Radolfzell (DE)
(72) Erfinder: Korherr, Joachim, 78315 Radolfzell (DE); Oksche, Annkathrin, 78315 Radolfzell (DE); Schubert, Timo, 78315 Radolfzell (DE); Lemcke, Soeren, 78315 Radolfzell (DE)
(74) Vertreter: Prinz & Partner mbB

(56) Entgegenhaltungen:
- EP-A1- 3 112 996
- WO-A2-2017/072232
- DE-A1-102015 002 300
- FR-A1- 3 035 981
- FR-A1- 3 056 474
- FR-A1- 3 056 475
- FR-A1- 3 058 938
- US-A1- 2016 364 014

## Beschreibung

Die Erfindung betrifft ein kapazitives Kraftfahrzeugbediensystem für den Innenraum eines Kraftfahrzeugs.

Aus dem Stand der Technik sind Kraftfahrzeugbediensysteme bekannt, mit denen Funktionen eines Kraftfahrzeugs ein- bzw. ausgeschaltet werden können, beispielsweise ein Multimediasystem eines Kraftfahrzeugs. Die Kraftfahrzeugbediensysteme umfassen üblicherweise durch mechanische Schalter und Ähnliches ausgebildete Bedienelemente, die von einem Fahrzeuginsassen gedrückt bzw. gedreht werden, um eine zugeordnete Funktion zu aktivieren bzw. zu deaktivieren.

Bei modernen Kraftfahrzeugen sind darüber hinaus kapazitive Kraftfahrzeugbediensysteme mit entsprechend kapazitiven Bedienelementen bekannt, die eine Annäherung bzw. ein Berühren erfassen, woraufhin das Kraftfahrzeugbediensystem eine zugeordnete Funktion ausführt. Die aus dem Stand der Technik bekannten kapazitiven Kraftfahrzeugbediensysteme sind jedoch verhältnismäßig komplex aufgebaut, wodurch die Herstellungskosten entsprechend hoch sind.

Darüber hinaus sind kapazitive Bildschirme zur Steuerung von Fahrzeugfunktionen bekannt, auf denen entsprechende Schaltsymbole bzw. Schaltflächen angezeigt werden, die ein Fahrzeuginsasse berühren bzw. denen er sich annähern kann, um eine zugeordnete Funktion auszuführen. Neben üblichen Schaltflächen sind auch sogenannte Gleitbereiche bekannt, entlang derer der Bediener des Kraftfahrzeugbediensystems beispielsweise seinen Finger gleiten lassen kann, um eine Funktion stufenlos oder stufenweise einzustellen. Bei der entsprechenden Funktion kann es sich um eine Lautstärkeregelung eines Multimediasystems handeln, bei der der Bediener des Kraftfahrzeugbediensystems seinen Finger entlang eines auf der kapazitiven Bedienoberfläche des kapazitiven Bildschirms dargestellten Bereichs bewegt, um die gewünschte Lautstärke einzustellen.

Als nachteilig hat sich bei den kapazitiven Bildschirmen herausgestellt, dass die zur Bedienung benötigten Flächen auf dem kapazitiven Bildschirm entsprechend groß sind, wodurch sich nur wenige Funktionen gleichzeitig auf dem kapazitiven Bildschirm abbilden lassen.

Die FR 3 056 475 A1, die FR 3 056 474 A1 und die FR 3 058 938 A1 offenbaren ein Kraftfahrzeugbediensystem, das einen Touchscreen und ein drehbares, auf dem Touchscreen angebrachtes Steuerelement aufweist, wobei eine Rotation des Steuerelements kapazitiv vom Touchscreen erfasst wird.

In der FR 3 035 981 A1 ist ein Drehschalter in einem Kraftfahrzeug beschrieben, der auf einem Touchscreen angeordnet ist.

Die DE 10 2015 002 300 A1 zeigt eine Eingabevorrichtung, die lateral verschiebbar an einer Halterung angebracht ist, wobei die Halterung an einer in Form eines Touchscreens ausgebildeten Eingabeeinrichtung befestigt ist.

Die Aufgabe der Erfindung ist es, ein einfach aufgebautes und leicht zu bedienendes Kraftfahrzeugbediensystem zur Verfügung zu stellen.

Die Aufgabe wird erfindungsgemäß gelöst durch ein kapazitives Kraftfahrzeugbediensystem, umfassend einen kapazitiven Bildschirm mit einer Bedienoberfläche sowie eine zum kapazitiven Bildschirm separat ausgebildete Druck- und Drehbetätigungsvorrichtung, die bereichsweise elektrisch leitfähig ist und zumindest teilweise auf der Bedienoberfläche des kapazitiven Bildschirms so befestigt ist, wobei die Druck- und Drehbetätigungsvorrichtung zumindest ein elektrisch leitfähiges Interaktionselement umfasst, das mit dem kapazitiven Bildschirm interagiert. Dabei erfolgt eine Druckbetätigung im Wesentlichen parallel zu einer Drehachse in Richtung des kapazitiven Bildschirms. Zudem liegt bei der Betätigung der Druck- und Drehbetätigungsvorrichtung eine elektrische Verbindung zwischen der Bedienoberfläche des kapazitiven Bildschirms und einem drehbaren Betätigungselement der Druck- und Drehbetätigungsvorrichtung vor. Die elektrische Verbindung ist über das zumindest eine elektrisch leitfähige Interaktionselement bereitgestellt, das die Bedienoberfläche bei der Betätigung kontaktiert. Die Druck- und Drehbetätigungsvorrichtung ist ringförmig ausgebildet. Das Kraftfahrzeugbediensystem ist ausgebildet, zumindest eine Druckbetätigung der Druck- und Drehbetätigungsvorrichtung mittels des kapazitiven Bildschirms in kapazitiver Weise zu erfassen. Die gesamte Druck- und Drehbetätigungsvorrichtung ist in einer vom Bildschirm aufgespannten Ebene lateral unbeweglich.

Der Grundgedanke der Erfindung ist es, dass eine elektrische Verbindung zwischen dem Bediener des Kraftfahrzeugbediensystems und dem kapazitiven Bildschirm, insbesondere der Bedienoberfläche, hergestellt wird, wenn der Bediener die zumindest bereichsweise elektrisch leitfähige Druck- und Drehbetätigungsvorrichtung berührt bzw. sich dieser annähert, wodurch eine elektrische Verbindung zwischen dem Bediener und dem kapazitiven Bildschirm über die hierzu separat ausgebildete Druck- und Drehbetätigungsvorrichtung hergestellt ist.

Da die Druck- und Drehbetätigungsvorrichtung auf der Bedienoberfläche des kapazitiven Bildschirms zumindest teilweise befestigt ist, ist es nicht möglich, dass die gesamte Druck- und Drehbetätigungsvorrichtung über den kapazitiven Bildschirm, insbesondere dessen Bedienoberfläche, bewegt wird, um eine entsprechende Funktion auf dem Bildschirm auszuführen. Erfindungsgemäß ist vielmehr vorgesehen, dass eine feste Zuordnung zwischen der Druck- und Drehbetätigungsvorrichtung sowie dem darunter angeordneten kapazitiven Bildschirm vorliegt, wodurch entsprechende Funktionen platzsparend aktiviert bzw. deaktiviert werden können. Mit anderen Worten ist die Druck- und Drehbetätigungsvorrichtung ortsfest auf dem kapazitiven Bildschirm angeordnet, da sie stets und unabhängig von der Aktion dieselbe Fläche auf dem kapazitiven Bildschirm einnimmt.

Beispielsweise lässt sich über die Drehbetätigung der Druck- und Drehbetätigungsvorrichtung eine Lautstärkenregelung vornehmen bzw. wird so durch ein Adressbuch gescrollt.

Die Druck- und Drehbetätigungsvorrichtung kann in einfacher Weise auf dem kapazitiven Bildschirm aufgeklebt sein, wodurch diese entsprechend ortsfest an dem kapazitiven Bildschirm befestigt ist.

Der kapazitive Bildschirm ist in gewohnter Weise eingerichtet, sodass er die Position und/oder die Bewegung des wenigstens einen elektrisch leitfähigen Interaktionselements der Druck- und Drehbetätigungsvorrichtung in Bezug auf den kapazitiven Bildschirm erfasst, sofern ein Kontakt zum kapazitiven Bildschirm vorliegt, und entsprechende Signale ausgibt, die in entsprechende Funktionen umgesetzt werden, beispielsweise von einer übergeordneten Steuer- und/oder Recheneinheit.

Generell können für die Druckbetätigung und die Drehbetätigung der Druck- und Drehbetätigungsvorrichtung separat ausgebildete Interaktionselemente vorgesehen sein, also zumindest ein Druckbetätigungs-Interaktionselement sowie zumindest ein Drehbetätigungs- Interaktionselement.

Insbesondere stellt die Druck- und Drehbetätigungsvorrichtung bei Betätigung eine haptische Rückmeldung bereit.

Zudem ist die gesamte Druck- und Drehbetätigungsvorrichtung in einer vom Bildschirm aufgespannten Ebene lateral unbeweglich.

Die Druck- und Drehbetätigungsvorrichtung kann eine ortsfeste Basis aufweisen, insbesondere in Bezug auf den kapazitiven Bildschirm. Die Druck- und Drehbetätigungsvorrichtung ist beispielsweise über die ortsfeste Basis auf dem kapazitiven Bildschirm befestigt, insbesondere derart dass die gesamte Druck- und Drehbetätigungsvorrichtung in einer vom Bildschirm aufgespannten Ebene lateral unbeweglich ist.

Um die Drehbetätigung der Druck- und Drehbetätigungsvorrichtung sicherzustellen, kann die Druck- und Drehbetätigungsvorrichtung ein, insbesondere ringförmig ausgebildetes, Betätigungselement aufweisen, das verstellbar ist. Eine Verdrehung des verstellbaren Betätigungselements in Bezug auf die Basis ist demnach möglich, um die Drehbetätigung zu realisieren.

Ferner lässt sich die Druck- und Drehbetätigungsvorrichtung um eine Drehachse drehen, die im Wesentlichen senkrecht zur Oberfläche des kapazitiven Bildschirms ist.

Die Druckbetätigung erfolgt demnach im Wesentlichen parallel zur Drehachse, also in Richtung des kapazitiven Bildschirms.

Über die elektrische Verbindung erkennt der kapazitive Bildschirm, dass die Druck- und Drehbetätigungsvorrichtung vom Bediener des Kraftfahrzeugbediensystems bedient wird. Die hergestellte elektrische Verbindung kann als ein Trigger-Signal bzw. Auslösesignal für das Kraftfahrzeugbediensystem angesehen werden. Die elektrische Verbindung wird über das zumindest eine elektrisch leitfähige Interaktionselement bereitgestellt, das die Bedienoberfläche bei Betätigung kontaktiert.

Sofern der Bediener eine Drehbetätigung der Druck- und Drehbetätigungsvorrichtung vornimmt, kann das elektrisch leitfähige Interaktionselement über die Bedienoberfläche bewegt werden, wobei der kapazitive Bildschirm die Bewegung entsprechend erkennt.

Der kapazitive Bildschirm kann ferner eingerichtet sein, die Fläche, also die Größe der Fläche, und/oder verschiedene Positionen auf der Bedienoberfläche zu erfassen, die vom Interaktionselement bei einer Betätigung der Druck- und Drehbetätigungsvorrichtung kontaktiert wird bzw. werden, um hierüber auf eine entsprechende Bedienung der Druck- und Drehbetätigungsvorrichtung zu schließen.

Beispielsweise führt eine Druckbetätigung der Druck- und Drehbetätigungsvorrichtung dazu, dass ein großer Flächenkontakt zwischen dem Interaktionselement und der Bedienoberfläche vorliegt, was von dem kapazitiven Bildschirm als Druckbetätigung erkannt wird, sodass eine mit der Druckbetätigung verknüpfte Funktion ausgeführt wird.

Insofern ist ein einfach aufgebautes Kraftfahrzeugbediensystem geschaffen, das eine entsprechende Druckbetätigung kapazitiv erfasst, wozu die Druck- und Drehbetätigungsvorrichtung bereichsweise elektrisch leitfähig ist, um mit dem kapazitiven Bildschirm zu interagieren. Eine Berührung des kapazitiven Bildschirms durch den Bediener ist somit nicht notwendig.

Gemäß einer Ausführungsform sind mehrere Interaktionselemente vorgesehen, über die der Drehwinkel der Druck- und Drehbetätigungsvorrichtung erfassbar ist. Alternativ oder ergänzend umfasst das wenigstens eine Interaktionselement mehrere Abschnitte, die separat voneinander betätigbar sind und über die der Drehwinkel der Druck- und Drehbetätigungsvorrichtung erfassbar ist, insbesondere wobei die mehreren Abschnitte jeweils eine haptische Rückmeldungsstruktur umfassen. Die mehreren Interaktionselemente sind über die der Druck- und Drehbetätigungsvorrichtung zugeordneten Fläche auf dem kapazitiven Bildschirm verteilt angeordnet. In Abhängigkeit von der Betätigung der Druck- und Drehbetätigungsvorrichtung ergibt sich somit ein unterschiedlicher Kontakt auf dem kapazitiven Bildschirm durch die mehreren Interaktionselemente. Beispielsweise kontaktiert nur eines der mehreren Interaktionselemente den kapazitiven Bildschirm, sodass über die Position des entsprechenden Interaktionselements auf dem kapazitiven Bildschirm auf die Drehbetätigung geschlossen werden kann, insbesondere den Drehwinkel. Hierbei kann die zeitliche Abfolge der jeweiligen Kontaktierungen des kapazitiven Bildschirms durch die mehreren Interaktionselemente berücksichtigt werden.

Alternativ oder ergänzend können elektrisch leitfähige Abschnitte eines (einstückig ausgebildeten) Interaktionselements vorgesehen sein, beispielsweise eines Blechs mit entsprechenden Segmenten bzw. Abschnitten, die in Abhängigkeit von der Betätigung der Druck- und Drehbetätigungsvorrichtung relativ zum kapazitiven Bildschirm verstellt werden, um diesen zu kontaktieren. Hierdurch ist dann eine elektrische Verbindung mit dem kapazitiven Bildschirm hergestellt, was entsprechend vom kapazitiven Bildschirm detektiert wird.

Ferner können die Abschnitte des (einteilig ausgebildeten Interaktionselements) jeweils eine haptische Rückmeldungsstruktur umfassen, die eine entsprechende taktile Rückmeldung an den Bediener bereitstellt, wenn die Druck- und Drehbetätigungsvorrichtung gedreht wird.

Des Weiteren kann die Druck- und Drehbetätigungsvorrichtung zumindest ein Kraftübertragungsglied aufweisen, das mit dem Interaktionselement zusammenwirkt. Bei dem Kraftübertragungsglied kann es sich um ein rollbares Kraftübertragungsglied handeln, beispielsweise einer Kugel, welches bei einer Drehbetätigung der Druck- und Drehbetätigungsvorrichtung relativ zur Bedienoberfläche bewegt werden kann.

Dabei kann das Kraftübertragungsglied relativ zu dem zumindest einen Interaktionselement bewegt werden, wobei es das zumindest eine Interaktionselement in einer zur Bedienoberfläche des kapazitiven Bildschirms senkrechten Richtung verstellt, wenn es über das zumindest eine Interaktionselement aufgrund der Drehbetätigung der Druck- und Drehbetätigungsvorrichtung bewegt wird. Insbesondere wird das Kraftübertragungsglied über das (einstückig ausgebildete) Interaktionselement bei einer Drehbetätigung der Druck- und Drehbetätigungsvorrichtung verfahren, wodurch es die entsprechend einzeln und separat voneinander betätigbaren Abschnitte relativ zum kapazitiven Bildschirm verstellt.

Es können auch mehrere Kraftübertragungsglieder vorgesehen sein, um eine homogene bzw. gleichmäßige Drehbetätigung der Druck- und Drehbetätigungsvorrichtung zu gewährleisten. Die mehreren Kraftübertragungsglieder sind dabei vorzugsweise im Wesentlichen gleich beabstandet zueinander.

Auch kann das Kraftübertragungsglied gleichzeitig das Interaktionselement sein, sofern das Kraftübertragungsglied elektrisch leitfähig ist. Bei dem Kraftübertragungsglied kann es sich um eine elektrisch leitfähige (und optional elastische) Kugel handeln.

Generell kann das Kraftübertragungsglied elektrisch leitfähig sein, sofern über das Kraftübertragungsglied die elektrische Verbindung vom drehbaren Betätigungselement zur Bedienoberfläche des kapazitiven Bildschirms ausgebildet wird.

Es kann das zumindest eine Interaktionselement, bei Betätigung der Druck- und Drehbetätigungsvorrichtung, eine zur Bedienoberfläche des kapazitiven Bildschirms relative Positionsveränderung erfahren. Die Betätigung der Druck- und Drehbetätigungsvorrichtung stellt somit sicher, dass das zumindest eine Interaktionselement relativ zur Bedienoberfläche des kapazitiven Bildschirms verstellt wird, was von dem kapazitiven Bildschirm entsprechend erfasst wird. Sofern das zumindest eine Interaktionselement über den kapazitiven Bildschirm bewegt wird, erfolgt über die Drehbewegung des Interaktionselements eine relative Positionsveränderung.

Beispielsweise erfolgt die relative Positionsveränderung in einer zur Bedienoberfläche des kapazitiven Bildschirms senkrechten Ebene. Dies ist insbesondere bei einer Druckbetätigung der Druck- und Drehbetätigungsvorrichtung der Fall. Darüber hinaus kann auch bei einer Drehbetätigung der Druck- und Drehbetätigungsvorrichtung eine zur Bedienoberfläche senkrechte relative Positionsveränderung des zumindest einen Interaktionselements auftreten. Dies ist insbesondere dann möglich, wenn mehrere (in Draufsicht und in Bezug auf den Bildschirm ortsfeste) Interaktionselemente vorgesehen sind, die unterschiedlichen Regionen des kapazitiven Bildschirms zugeordnet sind, wodurch eine orts- und/oder zeitaufgelöste Erfassung der Kontaktierung der mehreren Interaktionselemente erfolgt. Die mehreren Interaktionselemente können unabhängig voneinander durch das zumindest eine Kraftübertragungsglied senkrecht zu der vom kapazitiven Bildschirm aufgespannten Ebene verstellt werden, wenn das Kraftübertragungsglied mit dem entsprechenden Interaktionselement interagiert.

Ein weiterer Aspekt sieht vor, dass das wenigstens eine Interaktionselement durch zumindest einen Magneten ausgebildet ist. Über den Magneten kann die elektrische Verbindung in einfacher Weise entsprechend hergestellt werden. Ferner kann das Interaktionselement dann elektromagnetisch verstellt werden. Beispielsweise sind mehrere Magnete vorgesehen, die miteinander elektromagnetisch interagieren. Die mehreren Magnete können in zwei Ebenen angeordnet sein, wobei die Magnete beider Ebenen miteinander wechselwirken. Die eine Ebene der Magnete kann bei einer Drehbetätigung der Druck- und Drehbetätigungsvorrichtung relativ zur anderen Ebene der Magnete verdreht werden, sodass sich unterschiedliche Pole der Magnete gegenüberliegen, was zu einer abstoßenden elektromagnetischen Kraft führt, wodurch eine elektrische Kontaktierung des kapazitiven Bildschirms erfolgt.

Beispielsweise ist das wenigstens eine Interaktionselement elastisch, mechanisch vorgespannt und/oder elektromagnetisch vorgespannt. Hierdurch ist es möglich, dass sich die Druck- und Drehbetätigungsvorrichtung in eine Neutralstellung zurückstellt, wenn vom Bediener keine Kraft mehr ausgeübt wird, also nachdem die Druck- und Drehbetätigungsvorrichtung betätigt worden ist. Darüber hinaus kann über die Vorspannung eine haptische Rückmeldung für den Bediener des Kraftfahrzeugbediensystems erzeugt werden. Des Weiteren lässt sich über die Vorspannung sicherstellen, dass das zumindest eine Interaktionselement in der gewünschten Position verbleibt. Sofern das Interaktionselement elastisch ist, weist das Interaktionselement somit eine inhärente Vorspannung auf.

Ferner kann die Vorspannung eine Sicherheitsfunktion bereitstellen, da der kapazitive Bildschirm bei Betätigung der Druck- und Drehbetätigungsvorrichtung nicht beschädigt wird.

Auch kann vorgesehen sein, dass das wenigstens eine Interaktionselement durch eine elektrisch leitfähige Kugel ausgebildet ist, die beispielsweise zusätzlich elastisch ist. Bei einer Drehbetätigung der Druck- und Drehbetätigungsvorrichtung erzeugt die elektrisch leitfähige Kugel eine entsprechende elektrische Verbindung auf dem kapazitiven Bildschirm, wodurch die Betätigung der Druck- und Drehbetätigungsvorrichtung vom kapazitiven Bildschirm erfasst wird. Aufgrund der Elastizität ist ferner sichergestellt, dass eine taktile Rückmeldung erfolgt, die auch als haptische Rückmeldung bezeichnet wird.

Allgemein kann die Druck- und Drehbetätigungsvorrichtung wenigstens zwei elektrisch leitfähige Abschnitte umfassen, die als Interaktionselemente dienen und an unterschiedlichen Positionen in Bezug auf den kapazitiven Bildschirm vorgesehen sind. Die elektrisch leitfähigen Abschnitte können mit wenigstens einem (elektrisch leitfähigen) Kraftübertragungsglied zusammenwirken. Bei einer Drehbetätigung der Druck- und Drehbetätigungsvorrichtung werden die beiden elektrisch leitfähigen Abschnitte somit zu unterschiedlichen Zeitpunkten (über das zumindest eine Kraftübertragungsglied) betätigt, wodurch sich die Bewegungsrichtung der Druck- und Drehbetätigungsvorrichtung bei einer Drehbetätigung feststellen lässt.

Des Weiteren kann das Kraftfahrzeugbediensystem einen Drehgeber umfassen, über den der Drehwinkel der Druck- und Drehbetätigungsvorrichtung bei einer Drehbetätigung erfassbar ist. Der Drehgeber, auch Encoder genannt, kann auf unterschiedliche Weise ausgebildet sein.

Beispielsweise umfasst der Drehgeber einen optischen Sensor, einen Hall-Sensor und/oder eine induktive Spule. Dementsprechend lässt sich der Drehgeber neben der kapazitiven Weise auch in optischer und/oder elektromagnetischer Weise bereitstellen.

Das zumindest eine elektrisch leitfähige Interaktionselement kann demnach ausschließlich zur Druckbetätigung der Druck- und Drehbetätigungsvorrichtung dienen, da die Drehbetätigung der Druck- und Drehbetätigungsvorrichtung durch den Drehgeber erfasst wird, insbesondere in optischer und/oder elektromagnetischer Weise.

Ferner kann der kapazitive Bildschirm zumindest einen Anzeigebereich aufweisen, der der Druck- und Drehbetätigungsvorrichtung zugeordnet ist und, bei Betätigung der Druck- und Drehbetätigungsvorrichtung, eine optische Rückmeldung ausgibt. Demnach ist das kapazitive Kraftfahrzeugbediensystem gleichzeitig dazu ausgebildet, eine optische (sowie taktile) Rückmeldung bereitzustellen, sodass der Bediener des kapazitiven Kraftfahrzeugbediensystems sofort eine entsprechende Rückmeldung erhält.

Insbesondere umfasst die Druck- und Drehbetätigungsvorrichtung eine ortsfeste Basis und ein zur Basis verstellbares Betätigungselement. Die ortsfeste Basis ist dabei auf dem kapazitiven Bildschirm befestigt, insbesondere auf dem kapazitiven Bildschirm aufgeklebt. Das verstellbare Betätigungselement wird bei einer Dreh- bzw. Druckbetätigung relativ zur ortsfesten Basis bewegt. Bei einer Drehbetätigung ergibt sich demnach eine Verdrehung des verstellbaren Betätigungselements in Bezug auf die Basis. Das verstellbare Betätigungselement ist insbesondere elektrisch leitfähig ausgebildet.

Generell kann die Druck- und Drehbetätigungsvorrichtung ein elektrisch leitfähiges Interaktionselement umfassen, das für die Druckbetätigung der Druck- und Drehbetätigungsvorrichtung vorgesehen ist.

Zudem kann die Druck- und Drehbetätigungsvorrichtung ein elektrisch leitfähiges Interaktionselement umfassen, das für die Drehbetätigung der Druck- und Drehbetätigungsvorrichtung vorgesehen ist. Das elektrisch leitfähige Interaktionselement kann sich dabei über die Bedienoberfläche bewegen oder in einer hierzu senkrechten Richtung, insbesondere dann, wenn das elektrisch leitfähige Interaktionselement mit einem Kraftübertragungsglied zusammenwirkt.

Alternativ oder ergänzend kann vorgesehen sein, dass die Drehbetätigung der Druck- und Drehbetätigungsvorrichtung über einen Drehgeber bzw. einen Encoder erfasst wird, beispielsweise in kapazitiver, optischer und/oder elektromagnetischer Weise, also aufgrund von Induktion und/oder aufgrund des Hall-Effekts.

Das wenigstens eine Kraftübertragungsglied dient insbesondere dazu, eine Drehkraft in eine laterale Kraft zu übertragen bzw. zu übersetzen, indem das Kraftübertragungsglied beispielsweise mit dem elektrisch leitfähigen Interaktionselement zusammenwirkt und dieses verstellt.

Generell handelt es sich bei dem kapazitiven Bildschirm um ein Anzeigefeld, auf dem Inhalte dargestellt werden können, insbesondere aufgrund von elektrischen Ansteuerungssignalen. Der kapazitive Bildschirm ist zudem berührungs- bzw. annäherungssensitiv ausgebildet.

Weitere Vorteile und Eigenschaften ergeben sich aus der nachfolgenden Beschreibung und den Zeichnungen, auf die Bezug genommen wird. In den Zeichnungen zeigen:
- Figur 1 eine perspektivische Ansicht eines erfindungsgemäßen kapazitiven Kraftfahrzeugbediensystems,
- Figur 2 eine Schnittansicht durch ein kapazitives Kraftfahrzeugbediensystem gemäß einer ersten Ausführungsform,
- Figur 3 eine Ansicht auf die Unterseite der Druck- und Drehbetätigungsvorrichtung des Kraftfahrzeugbediensystems nach Figur 2,
- Figur 4 eine Explosionsansicht einer Druck- und Drehbetätigungsvorrichtung eines erfindungsgemäßen kapazitiven Kraftfahrzeugbediensystems gemäß einer zweiten Ausführungsform,
- Figur 5 eine Schnittansicht der Druck- und Drehbetätigungsvorrichtung nach Figur 4,
- Figur 6 eine Ansicht auf die Unterseite der Druck- und Drehbetätigungsvorrichtung nach Figur 4,
- Figur 7 eine perspektivische Ansicht eines Interaktionselements einer Druck- und Drehbetätigungsvorrichtung eines erfindungsgemäßen kapazitiven Kraftfahrzeugbediensystems,
- Figur 8 eine Explosionsansicht einer Druck- und Drehbetätigungsvorrichtung eines erfindungsgemäßen kapazitiven Kraftfahrzeugbediensystems gemäß einer dritten Ausführungsform,
- Figur 9 eine Schnittansicht der Druck- und Drehbetätigungsvorrichtung nach Figur 8,
- Figur 10 eine Ansicht von unten auf die Druck- und Drehbetätigungsvorrichtung nach Figur 8,
- Figur 11 eine Explosionsansicht einer Druck- und Drehbetätigungsvorrichtung eines erfindungsgemäßen kapazitiven Kraftfahrzeugbediensystems gemäß einer vierten Ausführungsform,
- Figur 12 eine Schnittansicht der Druck- und Drehbetätigungsvorrichtung nach Figur 11,
- Figur 13 eine Ansicht von unten auf die Druck- und Drehbetätigungsvorrichtung nach Figur 11,
- Figur 14 eine Explosionsansicht einer Druck- und Drehbetätigungsvorrichtung eines erfindungsgemäßen kapazitiven Kraftfahrzeugbediensystems gemäß einer fünften Ausführungsform,
- Figur 15 eine Schnittansicht der Druck- und Drehbetätigungsvorrichtung der nach Figur 14,
- Figur 16 eine Ansicht von unten auf die Druck- und Drehbetätigungsvorrichtung nach Figur 14,
- Figur 17 eine Schnittansicht eines erfindungsgemäßen kapazitiven Kraftfahrzeugbediensystems gemäß einer sechsten Ausführungsform,
- Figur 18 eine Ansicht von unten auf die Druck- und Drehbetätigungsvorrichtung des Kraftfahrzeugbediensystems nach Figur 17,
- Figur 19 eine Ansicht auf die Basis des Kraftfahrzeugbediensystems nach Figur 17,
- Figur 20 eine Schnittansicht eines erfindungsgemäßen kapazitiven Kraftfahrzeugbediensystems gemäß einer siebten Ausführungsform,
- Figur 21 eine Detailansicht der Figur 20,
- Figur 22 eine Ansicht von unten auf die Druck- und Drehbetätigungsvorrichtung des Kraftfahrzeugbediensystems nach Figur 20,
- Figur 23 eine perspektivische Darstellung eines Teils der Druck- und Drehbetätigungsvorrichtung des Kraftfahrzeugbediensystems nach Figur 20,
- Figur 24 eine Schnittansicht eines erfindungsgemäßen kapazitiven Kraftfahrzeugbediensystems gemäß einer achten Ausführungsform,
- Figur 25 eine teiltransparente Darstellung der Druck- und Drehbetätigungsvorrichtung des Kraftfahrzeugbediensystems nach Figur 24,
- Figur 26 eine Schnittdarstellung des Kraftfahrzeugbediensystems aus Figur 24,
- Figur 27 eine Schnittdarstellung eines erfindungsgemäßen kapazitiven Kraftfahrzeugbediensystems gemäß einer neunten Ausführungsform,
- Figur 28 eine Teildarstellung der Druck- und Drehbetätigungsvorrichtung des Kraftfahrzeugbediensystems nach Figur 27, und
- Figur 29 eine Ansicht von unten auf die Druck- und Drehbetätigungsvorrichtung des Kraftfahrzeugbediensystems nach Figur 27.

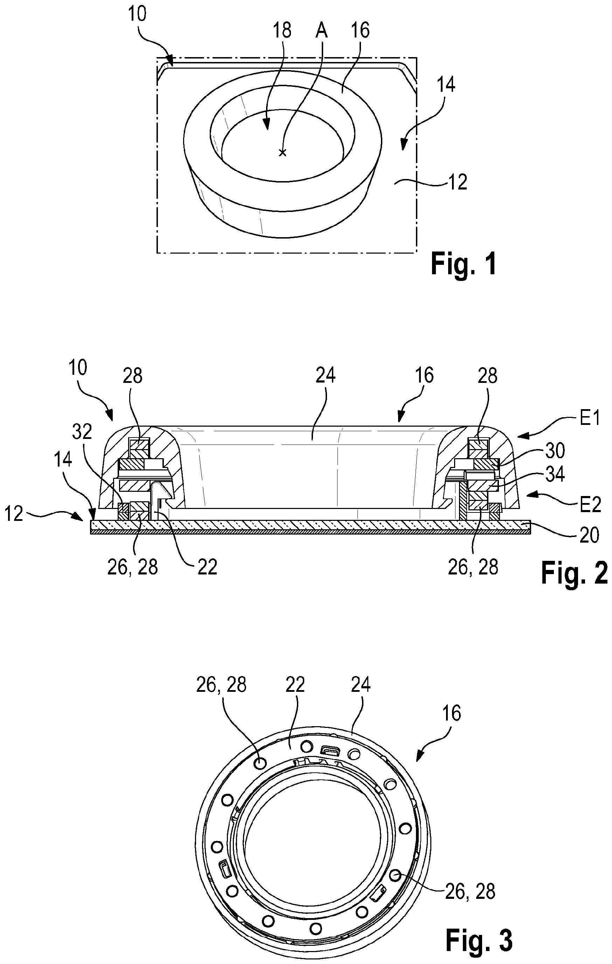

In Figur 1 ist ein kapazitives Kraftfahrzeugbediensystem 10 gezeigt, die in einem Innenraum eines Kraftfahrzeugs zum Einsatz kommt, um beispielsweise ein Multimediasystem und/oder Fahrzeugfunktionen eines Kraftfahrzeugs zu steuern.

Das kapazitive Kraftfahrzeugbediensystem 10 umfasst einen kapazitiven Bildschirm 12, der eine Bedienoberfläche 14 hat, sodass eine Berührung der Bedienoberfläche 14 oder eine Annäherung an die Bedienoberfläche 14 kapazitiv erfasst werden kann.

Des Weiteren umfasst das kapazitive Kraftfahrzeugbediensystem 10 eine Druck- und Drehbetätigungsvorrichtung 16, die separat zum kapazitiven Bildschirm 12 ausgebildet ist.

In der gezeigten Ausführungsform ist die Druck- und Drehbetätigungsvorrichtung 16 im Wesentlichen ringförmig ausgebildet, wobei die Druck- und Drehbetätigungsvorrichtung 16 zumindest teilweise auf der Bedienoberfläche 14 des kapazitiven Bildschirms 12 angeordnet ist. Dies bedeutet, dass die Druck- und Drehbetätigungsvorrichtung 16 eine Teilfläche der Bedienoberfläche 14 belegt.

Die Druck- und Drehbetätigungsvorrichtung 16 ist dabei auf dem kapazitiven Bildschirm 12 befestigt, indem die Druck- und Drehbetätigungsvorrichtung 16 beispielsweise mit dem kapazitiven Bildschirm 12 verklebt ist, wie nachfolgend noch erläutert wird.

Insofern ist sichergestellt, dass die Druck- und Drehbetätigungsvorrichtung 16 im Wesentlichen ortsfest in Bezug auf den kapazitiven Bildschirm 12 angeordnet ist. Dies bedeutet, dass die gesamte Druck- und Drehbetätigungsvorrichtung 16 nicht auf dem kapazitiven Bildschirm 12 verschoben werden kann, also lateral in der vom kapazitiven Bildschirm 12 aufgespannten Ebene bewegt werden kann, die der Bedienoberfläche 14 entspricht.

Die Druck- und Drehbetätigungsvorrichtung 16 ist bereichsweise elektrisch leitfähig ausgebildet, sodass eine elektrische Verbindung über die Druck- und Drehbetätigungsvorrichtung 16 zum kapazitiven Bildschirm 12 hergestellt werden kann, wenn ein Bediener des Kraftfahrzeugbediensystems 10 bzw. ein Fahrzeuginsasse das kapazitive Kraftfahrzeugbediensystem 10 über die Druck- und Drehbetätigungsvorrichtung 16 betätigt, also sich dieser annähert bzw. diese berührt.

Der kapazitive Bildschirm 12, der mit der bereichsweise elektrisch leitfähigen Druck- und Drehbetätigungsvorrichtung 16 zusammenwirkt, erkennt dann die Position und/oder eine Positionsveränderung der Druck- und Drehbetätigungsvorrichtung 16, insbesondere eines Teils der Druck- und Drehbetätigungsvorrichtung 16, wobei der kapazitive Bildschirm 12 entsprechende Signale erzeugt, um eine zugeordnete Funktion des Kraftfahrzeugs anzusteuern, wie nachfolgend noch detailliert erläutert wird.

Beispielsweise umfasst der kapazitive Bildschirm 12 an seiner Bedienoberfläche 14 einen Anzeigebereich 18, der der Druck- und Drehbetätigungsvorrichtung 16 zugeordnet ist, sodass bei Betätigung der Druck- und Drehbetätigungsvorrichtung 16 eine optische Rückmeldung auf dem kapazitiven Bildschirm 12 angezeigt werden kann, nämlich in dem entsprechenden Anzeigebereich 18.

Der Anzeigebereich 18 kann innerhalb der ringförmigen Druck- und Drehbetätigungsvorrichtung 16 vorgesehen sein, wie dies im Ausführungsbeispiel der Figur 1 gezeigt ist. Generell kann der Anzeigebereich 18 auch an einer anderen Stell auf dem kapazitiven Bildschirm 12 vorgesehen sein.

Die Druck- und Drehbetätigungsvorrichtung 16 ist generell eingerichtet, dass sie relativ zur Bedienoberfläche 14 des kapazitiven Bildschirms 12 gedreht werden kann, also in einer zur vom kapazitiven Bildschirm 12 aufgespannten Ebene parallelen Ebene. Die Drehachse A der Druck- und Drehbetätigungsvorrichtung 16 ist dabei ortsfest in Bezug auf den kapazitiven Bildschirm 12.

Des Weiteren lässt sich die Druck- und Drehbetätigungsvorrichtung 16 mittels einer Druckbetätigung im Wesentlichen senkrecht zu der vom kapazitiven Bildschirm 12 aufgespannten Ebene betätigen, beispielsweise in z-Richtung, wohingegen die Bedienoberfläche 14 sich in x- und y-Richtung erstreckt.

Je nach Betätigung der Druck- und Drehbetätigungsvorrichtung 16 wird die Bedienoberfläche 14 des kapazitiven Bildschirms 12 anders von der Druck- und Drehbetätigungsvorrichtung 16 in elektrisch leitender Weise kontaktiert, wodurch ein entsprechend unterschiedliches Kontaktmuster vom kapazitiven Bildschirm 12 erfasst und erkannt wird, das in eine entsprechend zugeordnete Funktion umgesetzt wird.

In den Figuren 2 und 3 ist eine kapazitive Kraftfahrzeugbediensystem 10 gemäß einer ersten Ausführungsform gezeigt, wobei die Druck- und Drehbetätigungsvorrichtung 16 auf einer Glasplatte 20 des kapazitiven Bildschirms 12 geklebt ist.

Aus der Figur 2 geht hervor, dass die Druck- und Drehbetätigungsvorrichtung 16 eine ortsfeste Basis 22 umfasst, insbesondere einen Basisring, über den die Druck- und Drehbetätigungsvorrichtung 16 auf dem kapazitiven Bildschirm 12 befestigt ist.

Ferner umfasst die Druck- und Drehbetätigungsvorrichtung 16 ein zur Basis 22 verstellbares Betätigungselement 24, beispielsweise einen Drehring, über das der Bediener des kapazitiven Kraftfahrzeugbediensystems 10 die Druck- und Drehbetätigungsvorrichtung 16 betätigt.

Darüber hinaus umfasst die Druck- und Drehbetätigungsvorrichtung 16 in der gezeigten Ausführungsform mehrere als Interaktionselemente 26 ausgebildete Magnete 28.

Generell sind mehrere Magnete 28 vorgesehen, die in zwei unterschiedlichen Ebenen E1, E2 angeordnet sind.

Eine erste Gruppe der Magnete 28, die der ersten Ebene E1 zugeordnet sind, ist über einen Fixierring 30 im drehbaren Betätigungselement 24 angeordnet, sodass sie sich mit dem drehbaren Betätigungselement 24 bewegen können, sofern dieses vom Bediener betätigt wird.

Eine zweite Gruppe der Magnete 28, die der zweiten Ebene E2 zugeordnet sind, sind im Bereich der Basis 22 angeordnet, wobei es sich bei diesen Magneten 28 um die Interaktionselemente 26 handelt, da sie mit dem kapazitiven Bildschirm 12 interagieren.

Die Interaktionselemente 26 bzw. Magnete 28 der zweiten Gruppe sind beweglich in einem elektrisch leitfähigen Führungsglied 32 angeordnet, das auch als Leitring bezeichnet werden kann, da das Führungsglied 32 ringförmig und elektrisch leitfähig ist.

Das Führungsglied 32 kontaktiert zumindest das drehbare Betätigungselement 24, sodass eine elektrische Verbindung zwischen dem elektrisch leitfähigen Betätigungselement 24 und dem Führungsglied 32 ausgebildet werden kann.

Es kann auch vorgesehen sein, dass das Führungsglied 32 bei einer Drehbewegung des drehbaren Betätigungselements 24 mitgedreht wird, also drehfest im Betätigungselement 24 angeordnet ist.

Darüber hinaus geht aus der Figur 2 hervor, dass die Druck- und Drehbetätigungsvorrichtung 16 einen Anschlag 34 aufweist, insbesondere einen Anschlagring, der die relative Bewegung der Interaktionselemente 26 bzw. Magnete 28, also der Magnete 28 der zweiten Gruppe, in z-Richtung beschränkt, wie nachfolgend erläutert wird, wenn auf die Funktionsweise der Kraftfahrzeugbediensystem 10 gemäß der ersten Ausführungsform eingegangen wird.

In der in Figur 2 gezeigten Stellung ist das Betätigungselement 24 bzw. der Drehring derart zur Basis 22 verdreht worden, dass die beiden Magnete 28 auf der in der Schnittdarstellung links gezeigten Seite mit ihren gleichartigen Polen zueinander weisen, wodurch sie sich voneinander abstoßen.

Dadurch wird der der Basis 22 zugeordnete Magnet 28, also das Interaktionselement 26, auf die Bedienoberfläche 14 des kapazitiven Bildschirms 12 (elektromagnetisch) gedrückt, sodass dieser die Bedienoberfläche 14 kontaktiert. Das Betätigungselement 24 bzw. der Drehring, der vom Bediener mit seinen Fingern berührt wird, ist elektrisch leitfähig, sodass eine elektrische Verbindung vom Bediener über das Betätigungselement 24, den Leitring 32, den entsprechenden Magneten 28 bzw. das Interaktionselement 26 zum kapazitiven Bildschirm 12 hergestellt ist. Dies wird vom kapazitiven Bildschirm 12 erkannt.

Eine Drehung der Druck- und Drehbetätigungsvorrichtung 16 erzeugt somit eine relative Positionsveränderung der Interaktionselemente 26, also der Magnete 28 in einer zur von dem kapazitiven Bildschirm 12 aufgespannten Ebene senkrechten Ebene, nämlich in z-Richtung, da die Bedienoberfläche 14 in x- und y-Richtung aufgespannt ist.

Wie auf deren rechten Seite der Figur 2 gezeigt ist, weisen die anderen Magnete 28 mit jeweils unterschiedlichen Polen aufeinander zu, wodurch sie sich gegenseitig anziehen. Die relative Anziehung der Magnete 28 wird dabei durch den Anschlag 34 begrenzt.

Aus der Figur 3, die eine Ansicht von unten auf die Druck- und Drehbetätigungsvorrichtung 16 zeigt, geht hervor, dass die der Basis 22 zugeordneten Magnete 28 jeweils im Wesentlichen homogen über die Basis 22 verteilt sind, also äquidistant in Umfangsrichtung.

Bei einer Drehbetätigung der Druck- und Drehbetätigungsvorrichtung 16 können mehrere Magnete 28 bzw. Interaktionselemente 26 die Bedienoberfläche 14 berühren, wodurch ein entsprechendes Betätigungsmuster auf dem kapazitiven Bildschirm 12 erzeugt wird, was vom kapazitiven Bildschirm 12 in ein entsprechendes Signal umgewandelt wird. Insbesondere wandern die Kontaktstellen der Interaktionselemente 26 auf der Bedienoberfläche 14 während einer Drehbetätigung, was vom kapazitiven Bildschirm 12 entsprechend erfasst wird.

Sofern die Druck- und Drehbetätigungsvorrichtung 16 gemäß der Kraftfahrzeugbediensystem 10 der ersten Ausführungsform eine Druckbetätigung erfährt, werden sämtliche Interaktionselemente 26, also die Magnete 28, die der Basis 22 zugeordnet sind, gleichzeitig auf die Bedienoberfläche 14 gedrückt, da das Betätigungselement 24 über den Anschlag 34 auf die entsprechenden Interaktionselemente 26 bzw. Magnete 28 der zweiten Gruppe wirkt. Insofern kann das Anschlag 34 bzw. der Anschlagring auch als Druckring bezeichnet werden, da über ihn die Druckfunktion der Druck- und Drehbetätigungsvorrichtung 16 sichergestellt ist, indem es die Druckkraft auf die Interaktionselemente 26 überträgt.

Sofern der Bediener die Druck- und Drehbetätigungsvorrichtung 16 nicht mehr drückt, wird diese aufgrund der magnetischen Vorspannung in ihre Neutralstellung zurückversetzt, die in Figur 2 gezeigt ist.

Bei der Druckbetätigung kann auch vorgesehen sein, dass das elektrisch leitfähige Betätigungselement 24, also der Drehring, mit seinem Umfang die Bedienoberfläche 14 berührt, was vom kapazitiven Bildschirm 12 entsprechend detektiert wird.

Darüber hinaus umfasst die Druck- und Drehbetätigungsvorrichtung 16 eine haptische Rückmeldung, die ebenfalls über die Magnete 28 erzeugt wird, insbesondere über die elektromagnetischen Kräfte der Magnete 28, also deren gegenseitige Anziehung bzw. Abstoßung je nach Polarität der sich gegenüberliegenden Pole der Magnete 28 beider Gruppen.

Insofern ergibt sich eine haptische Rückmeldung für den Bediener, die keinem Temperatureinfluss unterliegt. Auch weisen die Magnete 28 der zweiten Gruppe mehrere Funktionen gleichzeitig auf, da sie die Kontaktierung (Interaktion mit dem kapazitiven Bildschirm 12) als auch die haptische Rückmeldung sicherstellen.

Generell kann vorgesehen sein, dass die Interaktionselemente 26 eine Hubbewegung (in z-Richtung) von etwa 1 mm aufweisen, also sowohl bei der Drehbetätigung als auch der Druckbetätigung der Druck- und Drehbetätigungsvorrichtung 16.

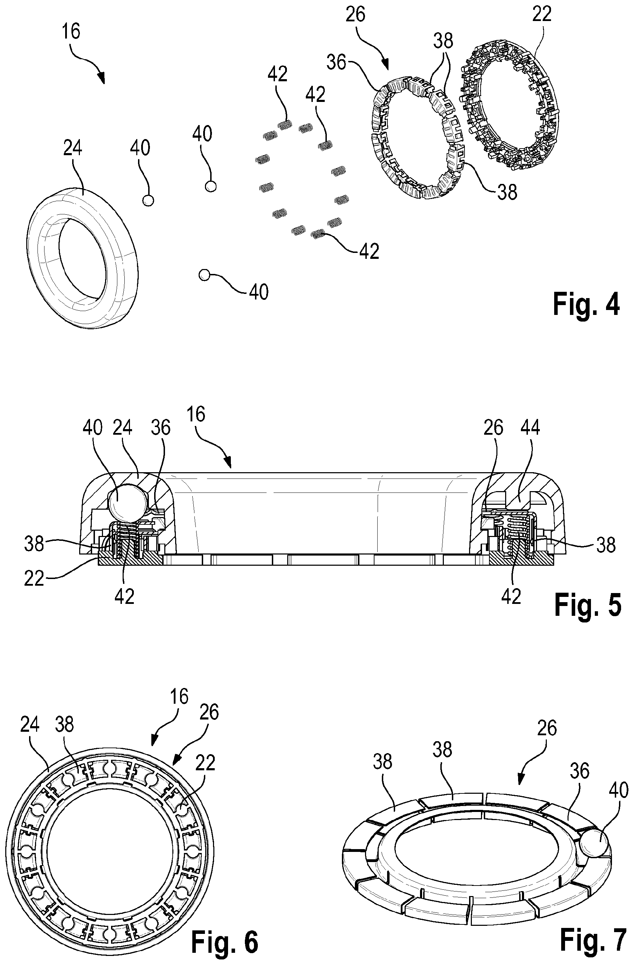

In den Figuren 4 bis 6 ist eine Druck- und Drehbetätigungsvorrichtung 16 eines kapazitiven Kraftfahrzeugbediensystems 10 gemäß einer zweiten Ausführungsform gezeigt, das sich von der ersten Ausführungsform dahingehend unterscheidet, dass die Interaktionselemente 26 durch ein einziges Interaktionselement 26 ersetzt worden ist.

Das Interaktionselement 26 ist durch einen Interaktionsring 36 ausgebildet und umfasst mehrere Abschnitte 38, die separat voneinander betätigbar sind, wie nachfolgend erläutert wird.

Aus der Explosionsansicht geht hervor, dass die Druck- und Drehbetätigungsvorrichtung 16 weiterhin eine Basis 22 umfasst, die direkt auf dem kapazitiven Bildschirm 12 befestigt wird, insbesondere geklebt wird, der aus Gründen der besseren Übersicht hier nicht gezeigt ist.

Darüber hinaus umfasst die Druck- und Drehbetätigungsvorrichtung 16 weiterhin ein zur Basis 22 verstellbares bzw. hierzu drehbares Betätigungselement 24, das elektrisch leitfähig ist.

Zudem sind in der zweiten Ausführungsform Kraftübertragungsglieder 40 vorgesehen, die jeweils kugelförmig ausgebildet sind und mit dem Interaktionselement 26 zusammenwirken.

Die mehreren Kraftübertragungsglieder 40 stellen sicher, dass eine möglichst gleichmäßige Bewegung bei der Drehbetätigung der Druck- und Drehbetätigungsvorrichtung 16 erfolgt.

Zumindest eines der Kraftübertragungsglieder 40 ist dabei elektrisch leitfähig, sodass eine elektrische Verbindung zwischen dem elektrisch leitfähigen Betätigungselement 24 und dem elektrisch leitfähigen Interaktionselement 26 über das elektrische leitfähige Kraftübertragungsglied 40 sichergestellt ist.

Die Kraftübertragungsglieder 40 sind drehfest mit dem Betätigungselement 24 gekoppelt, das hierzu beispielsweise an seiner Innengeometrie einen Aufnahmeraum für ein Kraftübertragungsglied 40 ausbilden, in dem das Kraftübertragungsglied 40 aufgenommen ist. Insofern werden bei einer Drehbetätigung des Betätigungselements 24 die Kraftübertragungsglieder 40 ebenfalls mit dem Betätigungselement 24 mitgedreht.

Der Aufnahmeraum kann durch Anschläge begrenzt und/oder eine entsprechende Kontur an der Innengeometrie ausgebildet sein.

Bei der Drehbetätigung der Druck- und Drehbetätigungsvorrichtung 16 bzw. des Betätigungselements 24 interagieren die Kraftübertragungsglieder 40 mit dem Interaktionsring 36, insbesondere den Abschnitten 38 des Interaktionsrings 36, da sich die Kraftübertragungsglieder 40 über den Interaktionsring 36 bewegen.

Sobald eines der Kraftübertragungsglieder 40 über einen Abschnitt 38 des Interaktionsrings 36 bewegt wird, wird der entsprechende Abschnitt 38 vom entsprechenden Kraftübertragungsglied 40, in z-Richtung gesehen, nach unten auf die Bedienoberfläche 14 gedrückt. Die mehreren Kraftübertragungsglieder 40 drücken also die bewegbaren Abschnitte 38 des Interaktionselements 26 bzw. Interaktionsrings 36 auf die Bedienoberfläche 14, wodurch zumindest bei dem elektrisch leitfähigen Kraftübertragungsglied 40 eine elektrische Verbindung vom Bediener über das elektrisch leitfähige Betätigungselement 24, das elektrisch leitfähige Kraftübertragungsglied 40 sowie den entsprechenden elektrisch leitfähigen Abschnitt 38 des Interaktionselements 26 zur Bedienoberfläche 14 hergestellt ist.

Darüber hinaus sind die Abschnitte 38 jeweils über eine Federelement 42 mechanisch in eine Neutralstellung vorgespannt, in der die Abschnitte 38 nicht die Bedienoberfläche 14 kontaktieren. Insofern ist das wenigstens eine Interaktionselement 26 mechanisch vorgespannt.

Hierüber wird ebenfalls eine taktile Rückmeldung der Druck- und Drehbetätigungsvorrichtung 16 bereitgestellt, da die Kraftübertragungsglieder 40 über die Federelemente 42 in z-Richtung nach oben gedrückt werden.

Sofern die Druck- und Drehbetätigungsvorrichtung 16 einer Druckbetätigung unterliegt, drückt das Betätigungselement 24 über einen innenseitig vorgesehenen Vorsprung 44 sowie die Kraftübertragungsglieder 40 sämtliche Abschnitte 38 gleichzeitig auf die Bedienoberfläche 14. Der Vorsprung 44 wirkt demnach mit dem Interaktionsring 36 bzw. dem Interaktionselement 26 zusammen.

Die Bedienoberfläche 14 wird so mit einem entsprechenden Kontaktierungsmuster betätigt, was vom kapazitiven Bildschirm 12 als Druckbetätigung erkannt wird.

Der Vorsprung 44 ist insbesondere derart ausgebildet, dass er einen Hubweg von 1 mm in z-Richtung aufweist.

Darüber hinaus stellen die Federelemente 42 sicher, dass die Druck- und Drehbetätigungsvorrichtung 16 den kapazitiven Bildschirm 12 nicht beschädigt, sofern eine zu große Kraft bei einer Druckbetätigung ausgeübt werden sollte, da die Federelemente 42 dieser Druckkraft entgegenwirken.

Grundsätzlich sind in der gezeigten Ausführungsform zwölf Abschnitte 38 sowie zwölf zugeordnete Federelemente 42 gezeigt, die jeweils in z-Richtung bewegt werden können, also in einer zu der vom kapazitiven Bildschirm 12 aufgespannten Ebene senkrechten Ebene.

In Figur 7 ist eine alternative Ausführung des Interaktionsrings 36 bzw. des Interaktionselements 26 gezeigt, das mehrere Abschnitte 38 umfasst, die einzeln und unabhängig voneinander betätigbar sind.

Der Interaktionsring 36 ist aus einem Blech gebildet, der entsprechend segmentiert ist, um die mehreren Abschnitte 38 bereitzustellen, die von dem zumindest einem Kraftübertragungsglied 40 relativ zur Bedienoberfläche 14 verstellt werden können.

Die Betätigung des in Figur 7 gezeigten Interaktionsrings 36 bzw. Interaktionselements 26 erfolgt im Wesentlichen in analoger Weise zur Betätigung des in den Figuren 4 bis 6 gezeigten Interaktionsrings 36 bzw. Interaktionselements 26.

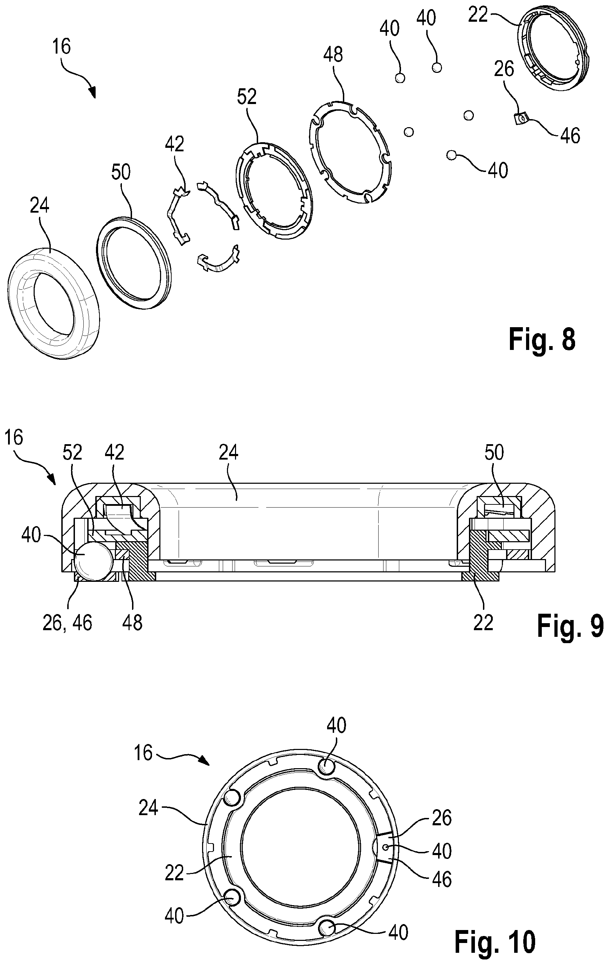

In den Figuren 8 bis 10 ist eine Druck- und Drehbetätigungsvorrichtung 16 eines kapazitiven Kraftfahrzeugbediensystems 10 gemäß einer dritten Ausführungsform gezeigt, bei der fünf Kraftübertragungsglieder 40 vorgesehen sind, von denen ein Kraftübertragungsglied 40 elektrisch leitfähig ist.

Dem elektrisch leitfähigen Kraftübertragungsglied 40 ist zudem das elektrisch leitfähige Interaktionselement 26 in Form eines Aufnahmeschuhs 46 zugeordnet, in dem das als Kugel ausgebildete Kraftübertragungsglied 40 aufgenommen ist.

In analoger Weise zur vorherigen Ausführungsform umfasst die Druck- und Drehbetätigungsvorrichtung 16 eine Basis 22, die auf dem kapazitiven Bildschirm 12 befestigt ist, insbesondere aufgeklebt ist. Ferner ist ein zur Basis 22 verstellbares bzw. drehbares Betätigungselement 24 vorgesehen, das elektrisch leitfähig ist und vom Bediener des Kraftfahrzeugbediensystems 10 betätigt wird.

Die Kraftübertragungsglieder 40, die wiederum allesamt als Kugeln ausgebildet sind, sind in einen Käfig 48 aufgenommen, sodass die Position der Kraftübertragungsglieder 40 relativ zueinander fix ist.

Den Kraftübertragungsgliedern 40 sind wiederum Federelemente 42 zugeordnet, über die die Kraftübertragungsglieder 40 und somit auch das wenigstens eine elektrisch leitfähige Interaktionselement 26, also der Aufnahmeschuh 46, mechanisch vorgespannt sind.

Zudem ist zwischen dem Betätigungselement 24 und den Federelementen 42 ein Zahnprofilring 50 vorgesehen, der ein Zahnprofil auf der zu den Federelementen 42 gerichteten Seiten aufweist. Hierüber lässt sich eine haptische Rückmeldung beim Betätigen der Druck- und Drehbetätigungsvorrichtung 16 bereitstellen.

Die Federelemente 42 sind zudem an einem Federhaltering 52 gehalten.

Bei einer Drehbetätigung der Druck- und Drehbetätigungsvorrichtung 16 wird die Drehbewegung des verstellbaren Betätigungselements 24 auf den Käfig 48 und somit auf die Kraftübertragungsglieder 40 übertragen, wobei der Aufnahmeschuh 46 bzw. das Interaktionselement 26 über die Bedienoberfläche 14 bewegt wird.

Die elektrische Verbindung wird dabei über das elektrisch leitfähige Betätigungselement 24, das wenigstens eine elektrisch leitfähige Kraftübertragungsglied 40 sowie den elektrisch leitfähigen Aufnahmeschuh 46 bzw. das elektrisch leitfähige Interaktionselement 26 sichergestellt.

Der Aufnahmeschuh 46 vergrößert die Auflagefläche auf der Bedienoberfläche 14 entsprechend.

Eine Druckbetätigung der Druck- und Drehbetätigungsvorrichtung 16 erfolgt dadurch, dass das Betätigungselement 24 über seinen gesamten Umfang mit der Bedienoberfläche 14 zusammenwirkt, wodurch ein entsprechend eindeutiges Signal vom kapazitiven Bildschirm 12 erzeugt wird.

Die Federelemente 42 sind dabei derart ausgebildet, dass sie einen Hubweg von ungefähr 1 mm in z-Richtung bei einer Druckbetätigung ermöglichen, bis sie flächig auf dem Federhaltering 52 aufliegen, also der Federweg aufgebraucht ist.

Sobald die Druckbetätigung nicht mehr vorliegt, drücken die Federelemente 42 das Betätigungselement 24 in seine Neutralstellung zurück.

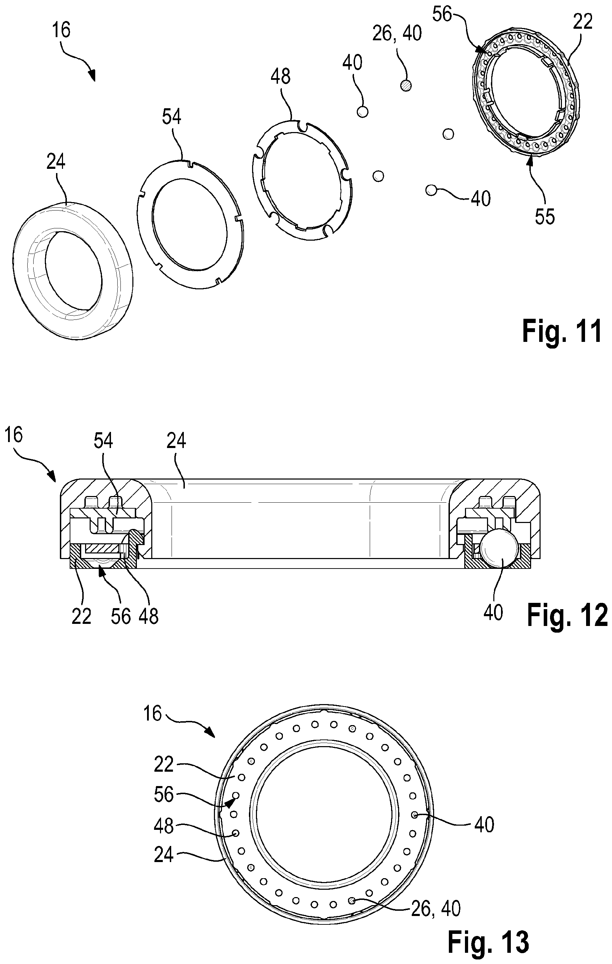

In den Figuren 11 bis 13 ist eine vierte Ausführungsform gezeigt, bei der in analoger Weise zur vorherigen Ausführungsform fünf Kraftübertragungsglieder 40 in Form von Kugeln vorgesehen sind.

Die Kraftübertragungsglieder 40 sind jedoch flexibel ausgebildet, sodass sie gleichzeitig eine haptische Rückmeldung, die Druckfunktion und eine Toleranzkompensation bereitstellen.

Eines der Kraftübertragungsglieder 40 ist wiederum elektrisch leitfähig ausgebildet, sodass eine elektrische Verbindung vom elektrisch leitfähigen Betätigungselement 24 über das elektrisch leitfähige Kraftübertragungsglied 40 zur Bedienoberfläche 14 des kapazitiven Bildschirms 12 sichergestellt werden kann.

Bei einer Drehbetätigung der Druck- und Drehbetätigungsvorrichtung 16 rotieren die Kraftübertragungsglieder 40 über die Basis 22, wobei wiederum ein Käfig 48 vorgesehen ist, der die Kraftübertragungsglieder 40 in ihren Positionen hält.

Die Drehbetätigung hat eine Drehbewegung der Kraftübertragungsglieder 40 zur Folge, wobei ein im Wesentlichen ringförmiger Drehmitnehmer 54 die Drehung des Betätigungselements 24 auf die im Käfig 48 angeordneten Kraftübertragungsglieder 40 überträgt. In der gezeigten Ausführungsform sind der Käfig 48 und der Drehmitnehmer 54 separat voneinander ausgebildet. Alternativ können diese jedoch auch gekoppelt oder sogar einstückig miteinander ausgebildet sein.

Der Drehmitnehmer 54 ist ebenfalls elektrisch leitfähig ausgebildet, sodass eine elektrische Verbindung vom Betätigungselement 24 über den Drehmitnehmer 54 zum elektrisch leitfähigen Kraftübertragungsglied 40 bzw. dem elektrisch leitfähiges Interaktionselement 26 vorliegt.

Die Basis 22 weist jeweils Ausnehmungen 56 auf, durch die zumindest das elektrisch leitfähige Kraftübertragungsglied 40 die Bedienoberfläche 14 kontaktieren kann, sodass das elektrisch leitfähige Kraftübertragungsglied 40 gleichzeitig das elektrisch leitfähige Interaktionselement 26 darstellt, das sich bei einer Drehbetätigung über die Bedienoberfläche 14 des kapazitiven Bildschirms 12 entsprechend bewegt, was vom kapazitiven Bildschirm 12 erfasst wird.

Bei einer Druckbetätigung der Druck- und Drehbetätigungsvorrichtung 16 wird das gesamte Betätigungselement 24 auf die Bedienoberfläche 14 des kapazitiven Bildschirms 12 gedrückt, also mit seinem gesamten Durchmesser, was vom kapazitiven Bildschirm 12 erkannt und in eine entsprechende Druckbetätigungsfunktion umgesetzt wird.

In dieser Ausführungsform sind keine separaten Federelemente bzw. Vorspannungselemente vorgesehen, da die Kraftübertagungsglieder 40 aufgrund ihrer Elastizität eine inhärente mechanische Vorspannung aufweisen.

Über die elastischen Kraftübertagungsglieder 40 lässt sich ein Hubweg von etwa 1 mm in z-Richtung einstellen, der bei einer Druckbetätigung überwunden werden muss.

Die elastischen Kraftübertagungsglieder 40 stellen zudem die Druck- und Drehbetätigungsvorrichtung 16 in ihre Neutralstellung zurück, sofern keine Druckbetätigung mehr vorliegt.

Die Basis 22 kann ferner einer entsprechende haptische Rückmeldungsstruktur 55 aufweisen, über die eine taktile Rückmeldung für den Bediener des Kraftfahrzeugbediensystems 10 erzeugt wird, wenn er die Druck- und Drehbetätigungsvorrichtung 16 betätigt. Dies liegt daran, dass die elastischen Kraftübertagungsglieder 40 aufgrund der haptischen Rückmeldungsstruktur 55 der Basis komprimieren und sich dann wieder entspannen.

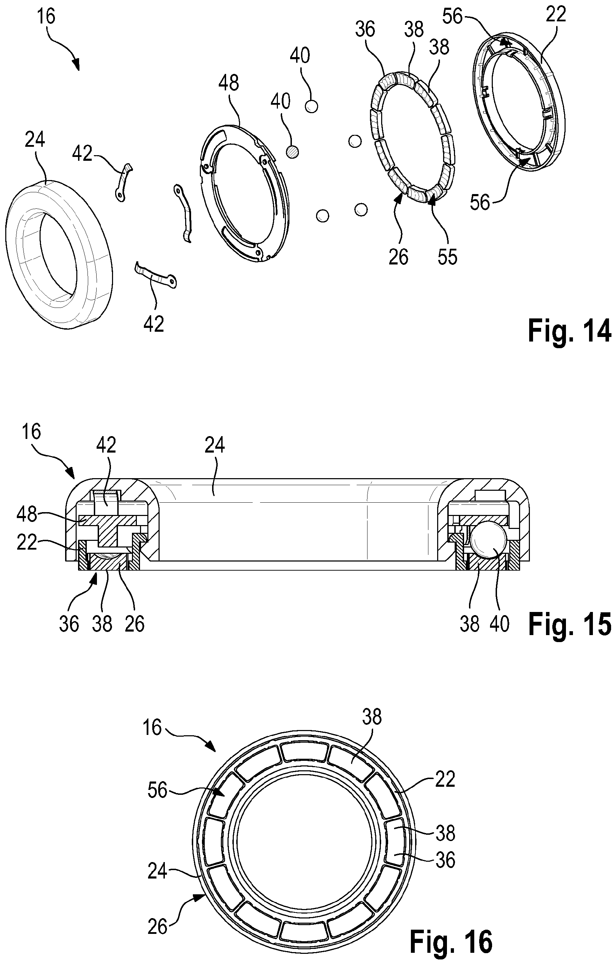

In den Figuren 14 bis 16 ist eine weitere Ausführungsform des kapazitiven Kraftfahrzeugbediensystems 10 gezeigt, bei dem das zumindest eine Interaktionselement 26 wiederum durch einen Interaktionsring 36 ausgebildet ist, der mehrere elektrisch leitfähige Abschnitte 38 umfasst, die jeweils separat und unabhängig voneinander betätigbar sind.

Die Abschnitte 38 weisen jeweils eine haptische Rückmeldungsstruktur 55 auf, die eine taktile Rückmeldung erzeugen, wenn die Druck- und Drehbetätigungsvorrichtung 16 vom Bediener betätigt wird, insbesondere wenn eine Drehbetätigung ausgeführt wird, bei der die als Kugeln ausgebildeten Kraftübertragungsglieder 40 entlang des Interaktionselements 26 bewegt werden, insbesondere den Abschnitten 38.

Aus den Figuren 15 und 16 geht hervor, dass das Interaktionselement 26 in der Basis 22 aufgenommen ist, die nicht elektrisch leitfähig ist. Die Basis 22 umfasst hierzu ebenfalls Ausnehmungen 56, durch die sich die einzelnen Abschnitte 38 erstrecken.

Von den mehreren Kraftübertragungsgliedern 40 ist zumindest ein Kraftübertragungsglied 40 elektrisch leitfähig, das entsprechend eine elektrische Verbindung zwischen dem elektrisch leitfähigen Betätigungselement 24 und dem elektrisch leitfähigen Abschnitt 38 des Interaktionselements 26 herstellt.

Bei der Betätigung der Druck- und Drehbetätigungsvorrichtung 16 wird demnach, wie bereits zuvor erläutert, eine elektrische Verbindung vom Bediener über das elektrisch leitfähige Betätigungselement 24 sowie das elektrisch leitfähige Kraftübertragungsglied 40 und dem zugeordneten elektrisch leitfähigen Abschnitt 38 des Interaktionselements 26 zum kapazitiven Bildschirm 12 hergestellt, da das Kraftübertragungsglied 40 den Abschnitt 38, in z-Richtung gesehen, nach unten drückt.

Wie bei den vorherigen Ausführungsformen bereits erläutert, rollen die als Kugeln bzw. Rollkörper ausgebildeten Kraftübertragungsglieder 40 bei einer Drehbetätigung der Druck- und Drehbetätigungsvorrichtung 16 entlang des Interaktionselements 26, insbesondere des Interaktionsrings 36, wobei die von den Kraftübertragungsgliedern 40 überrollten Abschnitte 38 auf den kapazitiven Bildschirm 12 gedrückt werden. Das elektrisch leitfähige Kraftübertragungsglied 40 stellt dann mit dem entsprechend heruntergedrückten Abschnitt 38 die elektrische Verbindung her, was vom kapazitiven Bildschirm 12 erfasst wird.

Über die separat betätigbaren Abschnitte 38 ist sichergestellt, dass eine verhältnismäßig große Betätigungsfläche des elektrisch leitfähigen Interaktionselements 26 auf dem kapazitiven Bildschirm 12 vorliegt, sodass die Betätigung leicht erfasst werden kann.

Um die Kraftübertragungsglieder 40 relativ zueinander in Position zu halten sind diese wiederum in einem Käfig 48 aufgenommen, der entsprechend drehfest mit dem Betätigungselement 24 gekoppelt ist.

Da die Abschnitte 38 eine haptische Rückmeldungsstruktur 55 umfassen, ergibt sich für den Bediener der Kraftfahrzeugbediensystem 10 bei der Drehbetätigung eine haptische Rückmeldung.

Des Weiteren umfasst die Druck- und Drehbetätigungsvorrichtung 16 wiederum Federelemente 42, über die die Druckbetätigung der Druck- und Drehbetätigungsvorrichtung 16 sowie die Rückstellung der Druck- und Drehbetätigungsvorrichtung 16 in die Neutralstellung sichergestellt ist.

Die Federelemente 42 können dabei so ausgebildet sein, dass sich bei einer Druckbetätigung wiederum ein Hubweg von ungefähr 1 mm der Druck- und Drehbetätigungsvorrichtung 16 in z-Richtung ergibt.

Bei einer Druckbetätigung der Druck- und Drehbetätigungsvorrichtung 16 wird das gesamte Betätigungselement 24, also der Drehring, auf die kapazitive Bedienoberfläche 14 des kapazitiven Bildschirms 12 gedrückt, sodass sein Außenumfang flächig aufliegt.

Hierdurch wird vom kapazitiven Bildschirm 12 ein entsprechendes Signal erzeugt.

Generell können die Kraftübertragungsglieder 40 elastisch ausgebildet sein, wodurch eine Beschädigung des kapazitiven Bildschirms 12 verhindert werden kann, wenn eine zu große Druckbetätigung ausgeübt wird.

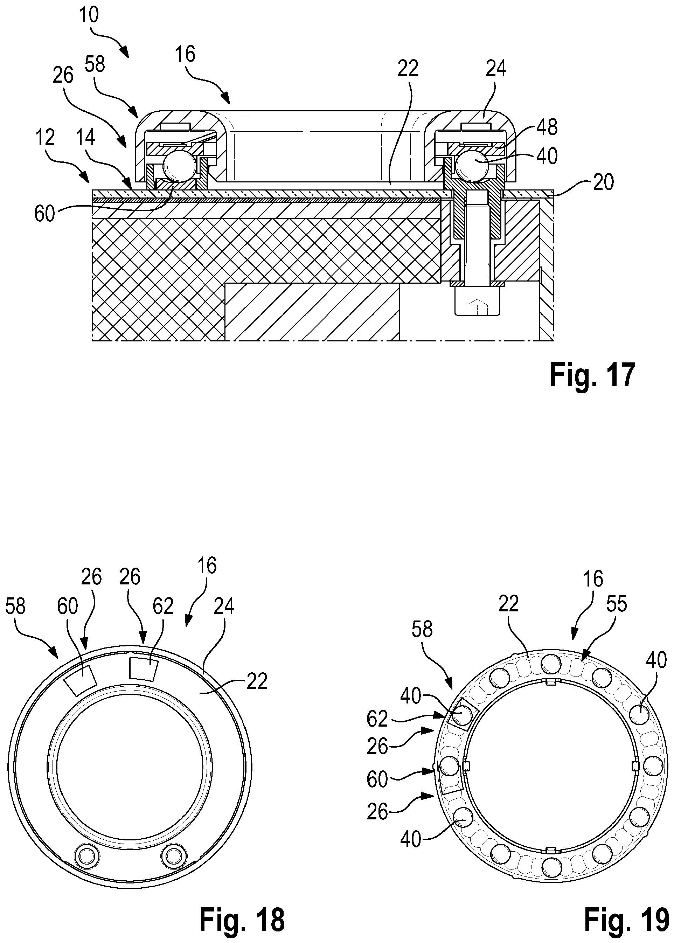

In den Figuren 17 bis 19 ist eine weitere Ausführungsform eines kapazitiven Kraftfahrzeugbediensystems 10 gezeigt, das einen Drehgeber 58 umfasst.

Der Drehgeber 58 kann generell den bei einer Drehbetätigung auftretenden Drehwinkel der Druck- und Drehbetätigungsvorrichtung 16 erfassen.

In der gezeigten Ausführungsform ist der Drehgeber 58 kapazitiv ausgebildet, da die Druck- und Drehbetätigungsvorrichtung 16 zwei voneinander separierte Detektionsbereiche 60, 62 aufweist, die voneinander um einen definierten Abstand beabstandet sind, wie insbesondere aus Figur 18 hervorgeht.

Die Detektionsbereiche 60, 62 sind elektrisch leitfähig ausgebildet und bilden demnach die elektrisch leitfähigen Interaktionselemente 26 aus, die mit dem kapazitiven Bildschirm 12 interagieren.

Die Druck- und Drehbetätigungsvorrichtung 16 weist ebenfalls mehrere Kraftübertragungsglieder 40 auf, die bei einer Drehbetätigung der Druck- und Drehbetätigungsvorrichtung 16 vom verstellbaren Betätigungselement 24 relativ zur Basis 22 verstellt werden, wobei sie - je nach Drehwinkel - mit den Detektionsbereichen 60, 62 interagieren, sodass sie eine elektrische Verbindung zur Bedienoberfläche 14 über den entsprechenden Detektionsbereich 60, 62 herstellen.

Die Kraftübertragungsglieder 40 sind demnach elektrisch leitfähig ausgebildet, wobei sie über einen Käfig 48 relativ zueinander in Position gehalten werden, also in Umfangsrichtung gesehen. Der Käfig 48 stellt demnach sicher, dass die Kraftübertragungsglieder 40 jeweils einen gleichen Abstand zueinander aufweisen.

Aufgrund des Abstands der Kraftübertragungsglieder 40 zueinander sowie des Abstands der Detektionsbereiche 60, 62 zueinander kann bei einer Drehbetätigung der Druck- und Drehbetätigungsvorrichtung 16 über die beiden Detektionsbereiche 60, 62 bzw. die beiden Interaktionselemente 26 festgestellt werden, um welchen Winkel und in welche Richtung die Druck- und Drehbetätigungsvorrichtung 16 gedreht wird.

Hierzu wird auf die Zeitauflösung der elektrischen Verbindungen der beiden Detektionsbereiche 60, 62 bzw. der beiden Interaktionselemente 26 abgestellt.

Über die Anzahl der Betätigung der jeweiligen Detektionsbereiche 60, 62 lässt sich der Drehwinkel entsprechend ermitteln.

Bei einer Druckbetätigung der Druck- und Drehbetätigungsvorrichtung 16 wird wiederum das gesamte Betätigungselement 24 über seinen (Außen-)Durchmesser auf die Bedienoberfläche 14 gedrückt, was entsprechend vom kapazitiven Bildschirm 12 erfasst wird.

Wie unter anderem aus der Figur 17 hervorgeht, kann die zum kapazitiven Bildschirm 12 separat ausgebildete Druck- und Drehbetätigungsvorrichtung 16 generell auch über eine mechanische Verbindung wie einer Schraubverbindung oder ähnlichem an dem kapazitiven Bildschirm 12 befestigt sein, insbesondere zusätzlich zu einer stoffschlüssigen Verbindung, also einer Klebung.

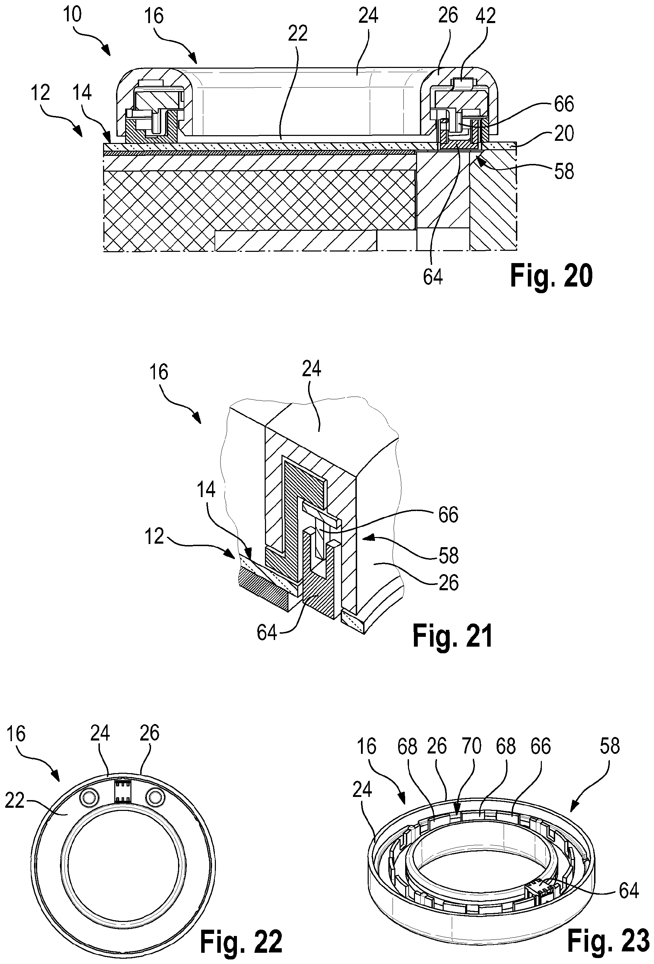

In den Figuren 20 bis 22 ist eine weitere Ausführungsform gezeigt, bei der der Drehgeber 58 einen optischen Sensor 64 umfasst, also den Drehwinkel in optischer Weise erfasst. Der optische Sensor 64 umfasst wenigstens einen Lichtsender sowie einen Lichtempfänger.

Zudem weist der Drehgeber 58 einen Codierring 66 auf, der dem verstellbaren Betätigungselement 24 zugeordnet ist, beispielsweise mit dem Betätigungselement 24 drehfest gekoppelt ist, sodass der Codierring 66 mitgedreht wird, wenn das Betätigungselement 24 gedreht wird.

Der Codierring 66 umfasst mehrere Abschnitte 68, die durch Ausnehmungen 70 voneinander getrennt sind. Durch die Ausnehmungen 70 kann ein vom optischen Sensor 64 ausgesandter Lichtstrahl durchtreten, was vom optischen Sensor 64 wiederum erfasst wird.

Insofern sind der Lichtsender und der Lichtempfänger entgegengesetzten Seiten des Codierrings 66 zugeordnet.

Der optische Sensor 64 erfasst bei einer Drehbetätigung der Druck- und Drehbetätigungsvorrichtung 16 demnach die aufgrund des Codierrings 66 auftretenden optischen Veränderungen, um auf den entsprechenden Drehwinkel bei der Drehbetätigung zu schließen.

Die optischen Veränderungen werden dadurch hervorgerufen, dass das Licht vom Sender des optischen Sensors 64 durch eine der Ausnehmungen 70 treten und vom Empfänger des optischen Sensors 64 empfangen werden kann bzw. durch einen der Abschnitte 68 geblockt wird.

Sofern der optische Sensor 64 mit zwei Lichtstrahlen arbeitet, beispielsweise mit zwei Lichtsendern und zwei Lichtempfängern, kann zudem die Drehrichtung bei der Drehbetätigung der Druck- und Drehbetätigungsvorrichtung 16 erkannt werden.

Wie aus den Figuren 20 und 21 hervorgeht, ist der optische Sensor 64 der Glasplatte 20 des kapazitiven Bildschirms 12 zugeordnet, insbesondere in der Glasplatte 20 teilweise aufgenommen. Hierzu wird die Glasplatte 20 zumindest teilweise durchbohrt.

Die Druckbetätigung der Druck- und Drehbetätigungsvorrichtung 16 erfolgt dabei in bekannter Weise, indem Federelemente 42 zusammengedrückt werden, bis das elektrisch leitfähige Betätigungselement 24 mit dem kapazitiven Bildschirm 12, insbesondere der Bedienoberfläche 14, in Kontakt kommt, was vom kapazitiven Bildschirm 12 entsprechend erfasst wird. Insofern stellt das Betätigungselement 24 das Interaktionselement 26 dar, das mit dem kapazitiven Bildschirm 12 interagiert.

Die Federelemente 42 stellen die haptische Rückmeldung bereit und sorgen ferner dafür, dass das Betätigungselement 24 in seine Neutralstellung zurückkehrt.

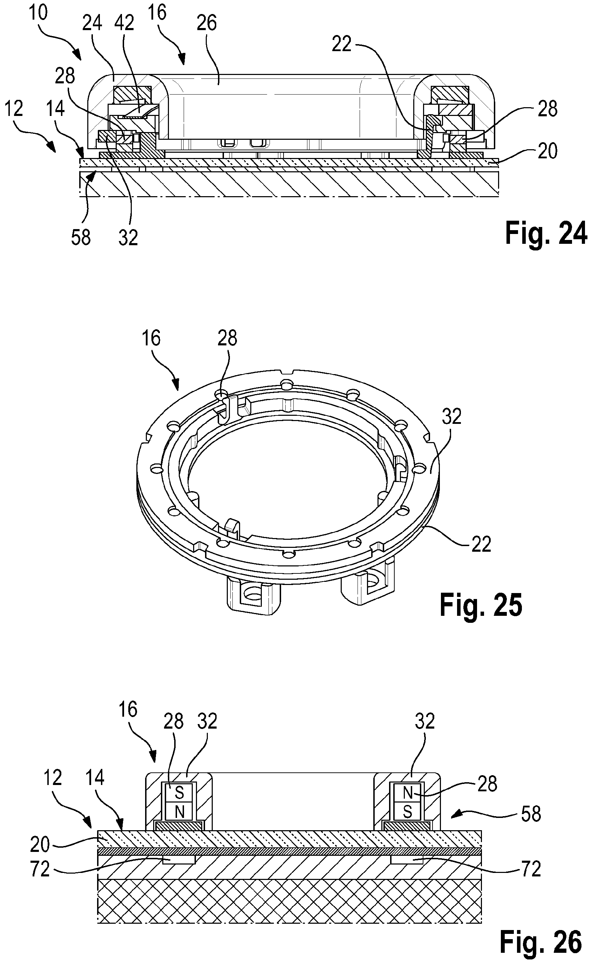

In den Figuren 24 bis 26 ist eine weitere Ausführungsform gezeigt, bei der der Drehgeber 58 wenigstens einen Hall-Sensor 72 umfasst, der mit Magneten 28 wechselwirkt, die dem Betätigungselement 24 zugeordnet sind.

Die Magnete 28 können in einem Führungsglied 32 angeordnet sein, das auch als Leitring bezeichnet werden kann. Das Führungsglied 32 kann wiederum mit dem Betätigungselement 24 drehfest gekoppelt sein, sodass sich die Magnete 28 bei einer Drehbetätigung über die Bedienoberfläche 14 bewegen, und somit auch über die Hall-Sensoren 72.

Wenn die Druck- und Drehbetätigungsvorrichtung 16 gedreht wird, bewirken die Magnete 28 eine Magnetflussänderung, welche vom Hall-Sensor 72 erfasst wird.

Hierzu sind die Magnete 28 insbesondere mit wechselnder Polarität der Bedienoberfläche 14 zugeordnet.

Die Hall-Sensoren 72 können unterhalb der Glasplatte 20 des kapazitiven Bildschirms 12 angeordnet sein, beispielsweise unterhalb der kapazitiven Sensorschicht des kapazitiven Bildschirms 12.

Die Magnete 28 können die Interaktionselemente 26 darstellen, wie dies zuvor anhand der Figuren 2 und 3 bereits erläutert worden ist.

Alternativ kann das Betätigungselement 24 das Interaktionselement 26 darstellen, sofern eine Druckbetätigung ausgeübt wird, wie bereits zuvor beschrieben wurde.

Die Federelemente 42 können wiederum zur haptischen Rückmeldung dienen und einen Hubweg in z-Richtung von ungefähr 1 mm bereitstellen.

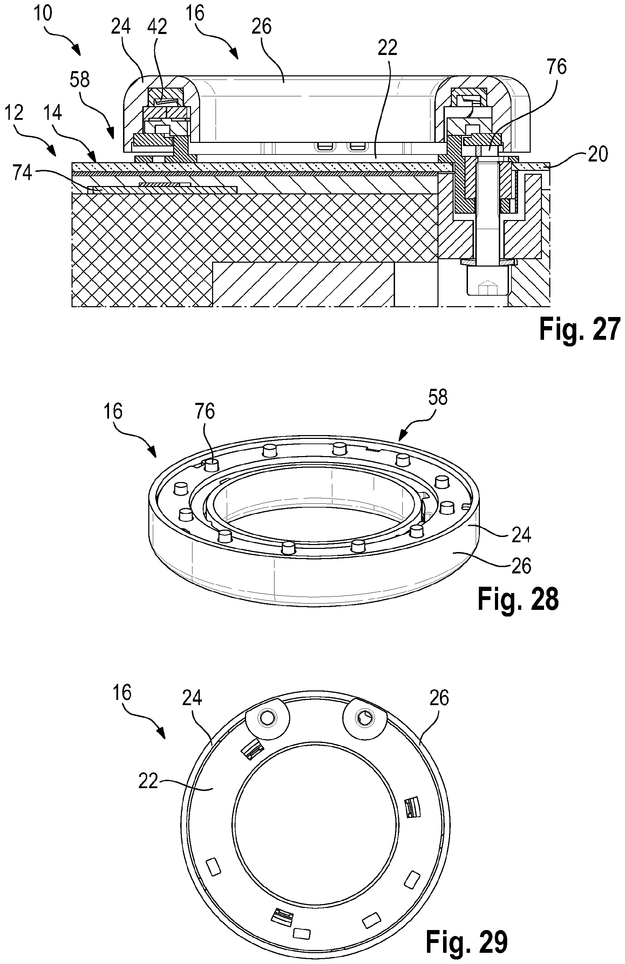

In den Figuren 27 bis 29 ist eine weitere Ausführungsform gezeigt, bei der der Drehgeber 58 wenigstens eine induktive Spule 74 umfasst, die beispielsweise über ein FPC-Kabel ausgebildet ist.

Das FPC-Kabel ist ebenfalls unterhalb der Glasplatte 20 des kapazitiven Bildschirms 12 angeordnet, wobei eine Induktivitätsänderung von der wenigstens einen induktiven Spule 74 erfasst wird, um eine Drehung der Druck- und Drehbetätigungsvorrichtung 16 zu erfassen.

Hierzu ist dem Betätigungselement 24 ein Induktionsmaterial 76 wie ein Eisenstück zugeordnet, was von der wenigstens einen induktiven Spule 74 entsprechend erfasst wird, wenn die Betätigungselement 24 gedreht wird, also einer Drehbetätigung unterzogen wird.

Sofern zwei induktive Spulen 74 vorgesehen sind, lässt sich so auch die Drehrichtung der Druck- und Drehbetätigungsvorrichtung 16 erfassen.

Die Druckbetätigung kann dabei wieder gegen die Federkraft der Federelemente 42 erfolgen, sodass das Betätigungselement 24 als das Interaktionselement 26 dient, da das elektrisch leitfähige Betätigungselement 24 mit dem kapazitiven Bildschirm 12 interagiert.

## Patentansprüche

1. Kapazitives Kraftfahrzeugbediensystem (10), umfassend einen kapazitiven Bildschirm (12) mit einer Bedienoberfläche (14) sowie eine zum kapazitiven Bildschirm (12) separat ausgebildete Druck- und Drehbetätigungsvorrichtung (16), die bereichsweise elektrisch leitfähig ist und zumindest teilweise auf der Bedienoberfläche (14) des kapazitiven Bildschirms (12) befestigt ist, wobei die Druck- und Drehbetätigungsvorrichtung (16) zumindest ein elektrisch leitfähiges Interaktionselement (26, 36) umfasst, das mit dem kapazitiven Bildschirm (12) interagiert, wobei eine Druckbetätigung im Wesentlichen parallel zu einer Drehachse (A) in Richtung des kapazitiven Bildschirms (12) erfolgt, wobei bei der Betätigung der Druck- und Drehbetätigungsvorrichtung (16) eine elektrische Verbindung zwischen der Bedienoberfläche (14) des kapazitiven Bildschirms (12) und einem drehbaren Betätigungselement (24) der Druck- und Drehbetätigungsvorrichtung (16) vorliegt, und wobei die elektrische Verbindung über das zumindest eine elektrisch leitfähige Interaktionselement (26, 36) bereitgestellt ist, das die Bedienoberfläche (14) bei der Betätigung kontaktiert, **dadurch gekennzeichnet, dass** die Druck- und Drehbetätigungsvorrichtung (16) ringförmig ausgebildet ist, wobei das Kraftfahrzeugbediensystem (10) ausgebildet ist, zumindest eine Druckbetätigung der Druck- und Drehbetätigungsvorrichtung (16) mittels des kapazitiven Bildschirms (12) in kapazitiver Weise zu erfassen, und wobei die gesamte Druck- und Drehbetätigungsvorrichtung (16) in einer vom Bildschirm (12) aufgespannten Ebene lateral unbeweglich ist.

2. Kapazitives Kraftfahrzeugbediensystem (10) nach Anspruch 1, **dadurch gekennzeichnet, dass** mehrere Interaktionselemente (26) vorgesehen sind, über die der Drehwinkel der Druck- und Drehbetätigungsvorrichtung (16) erfassbar ist und/oder dass das wenigstens eine Interaktionselement (26) mehrere Abschnitte (28) umfasst, die separat voneinander betätigbar sind und über die der Drehwinkel der Druck- und Drehbetätigungsvorrichtung (16) erfassbar ist, insbesondere wobei die mehreren Abschnitte (38) jeweils eine haptische Rückmeldungsstruktur (55) umfassen.

3. Kapazitives Kraftfahrzeugbediensystem (10) nach einem der vorhergehenden Ansprüche, **dadurch gekennzeichnet, dass** die Druck- und Drehbetätigungsvorrichtung (16) zumindest ein Kraftübertragungsglied (40) aufweist, das mit dem Interaktionselement (26) zusammenwirkt.

4. Kapazitives Kraftfahrzeugbediensystem (10) nach einem der vorhergehenden Ansprüche, **dadurch gekennzeichnet, dass** das zumindest eine Interaktionselement (26), bei Betätigung der Druck- und Drehbetätigungsvorrichtung (16), eine zur Bedienoberfläche (14) des kapazitiven Bildschirms (12) relative Positionsveränderung erfährt.

5. Kapazitives Kraftfahrzeugbediensystem (10) nach Anspruch 4, **dadurch gekennzeichnet, dass** die relative Positionsveränderung in einer zur Bedienoberfläche (14) des kapazitiven Bildschirms (12) senkrechten Ebene erfolgt.

6. Kapazitives Kraftfahrzeugbediensystem (10) nach einem der vorhergehenden Ansprüche, **dadurch gekennzeichnet, dass** das wenigstens eine Interaktionselement (26) durch zumindest einen Magneten (28) ausgebildet ist.

7. Kapazitives Kraftfahrzeugbediensystem (10) nach einem der vorhergehenden Ansprüche, **dadurch gekennzeichnet, dass** das wenigstens eine Interaktionselement (26) elastisch ist, mechanisch vorgespannt ist und/oder elektromagnetisch vorgespannt ist.

8. Kapazitives Kraftfahrzeugbediensystem (10) nach einem der vorhergehenden Ansprüche, **dadurch gekennzeichnet, dass** das Kraftfahrzeugbediensystem (10) einen Drehgeber (58) umfasst, über den der Drehwinkel der Druck- und Drehbetätigungsvorrichtung (16) bei einer Drehbetätigung erfassbar ist.

9. Kapazitives Kraftfahrzeugbediensystem (10) nach Anspruch 8, **dadurch gekennzeichnet, dass** der Drehgeber (58) einen optischen Sensor (64), einen Hall-Sensor (72) und/oder eine induktive Spule (74) umfasst.

10. Kapazitives Kraftfahrzeugbediensystem (10) nach einem der vorhergehenden Ansprüche, **dadurch gekennzeichnet, dass** der kapazitive Bildschirm (12) zumindest einen Anzeigebereich (18) aufweist, der der Druck- und Drehbetätigungsvorrichtung (16) zugeordnet ist und, bei Betätigung der Druck- und Drehbetätigungsvorrichtung (16), eine optische Rückmeldung ausgibt.

11. Kapazitives Kraftfahrzeugbediensystem (10) nach einem der vorhergehenden Ansprüche, **dadurch gekennzeichnet, dass** die Druck- und Drehbetätigungsvorrichtung (16) eine ortsfeste Basis (22) und ein zur Basis (22) verstellbares Betätigungselement (24) umfasst.

## Claims

1. A capacitive motor vehicle operating system (10) comprising a capacitive screen (12) having an operator interface (14) and a pressure- and rotational-actuation device (16) which is formed separately from the capacitive screen (12) and is electrically conductive in areas and is at least partially affixed to the operator interface (14) of the capacitive screen (12), the pressure- and rotational-actuation device (16) comprising at least one electrically conductive interaction element (26, 36) which interacts with the capacitive screen (12), wherein a pressure actuation is effected substantially parallel to a rotational axis (A) towards the capacitive screen (12), wherein, during actuation of the pressure- and rotational-actuation device (16), there is an electrical connection between the operator interface (14) of the capacitive screen (12) and a rotatable actuation element (24) of the pressure- and rotational-actuation device (16), and wherein the electrical connection is provided via the at least one electrically conductive interaction element (26, 36) which contacts the operator interface (14) during actuation, **characterized in that** the pressure- and rotational-actuation device (16) is formed to be ring-shaped, the motor vehicle operating system (10) being configured to detect at least one pressure actuation of the pressure- and rotational-actuation device (16) by means of the capacitive screen (12) in a capacitive manner, and the entire pressure- and rotational-actuation device (16) being laterally immobile in a plane spanned by the screen (12).

2. The capacitive motor vehicle operating system (10) according to claim 1, **characterized in that** several interaction elements (26) are provided, via which the angle of rotation of the pressure- and rotational-actuation device (16) can be detected and/or **in that** the at least one interaction element (26) comprises several sections (28) which can be actuated separately from each other and via which the angle of rotation of the pressure- and rotational-actuation device (16) can be detected, in particular wherein the several sections (38) each comprise a haptic feedback structure (55).

3. The capacitive motor vehicle operating system (10) according to either of the preceding claims, **characterized in that** the pressure- and rotational-actuation device (16) has at least one force transmission element (40) which cooperates with the interaction element (26).

4. The capacitive motor vehicle operating system (10) according to any of the preceding claims, **characterized in that** upon actuation of the pressure- and rotational-actuation device (16), the at least one interaction element (26) experiences a change in position relative to the operator interface (14) of the capacitive screen (12).

5. The capacitive motor vehicle operating system (10) according to claim 4, **characterized in that** the relative change in position is effected in a plane perpendicular to the operator interface (14) of the capacitive screen (12).

6. The capacitive motor vehicle operating system (10) according to any of the preceding claims, **characterized in that** the at least one interaction element (26) is formed by at least one magnet (28).

7. The capacitive motor vehicle operating system (10) according to any of the preceding claims, **characterized in that** the at least one interaction element (26) is elastic, is mechanically biased and/or electromagnetically biased.

8. The capacitive motor vehicle operating system (10) according to any of the preceding claims, **characterized in that** the motor vehicle operating system (10) comprises a rotary encoder (58) via which the angle of rotation of the pressure-and rotational-actuation device (16) during a rotational actuation can be detected.

9. The capacitive motor vehicle operating system (10) according to claim 8, **characterized in that** the rotary encoder (58) comprises an optical sensor (64), a Hall effect sensor (72) and/or an inductive coil (74).

10. The capacitive motor vehicle operating system (10) according to any of the preceding claims, **characterized in that** the capacitive screen (12) has at least one display area (18) which is assigned to the pressure-and rotational-actuation device (16) and, upon actuation of the pressure- and rotational-actuation device (16), outputs a visual feedback.

11. The capacitive motor vehicle operating system (10) according to any of the preceding claims, **characterized in that** the pressure- and rotational-actuation device (16) comprises a stationary base (22) and an actuation element (24) displaceable with respect to the base (22).

## Revendications

1. Système de commande capacitif (10) de véhicule automobile, comprenant un écran capacitif (12) qui présente une interface utilisateur (14) et un dispositif d'actionnement par pression et rotation (16) qui est réalisé séparément de l'écran capacitif (12), qui est électriquement conducteur par tronçons, et qui est au moins partiellement fixé sur l'interface utilisateur (14) de l'écran capacitif (12), le dispositif d'actionnement par pression et rotation (16) comprenant au moins un élément d'interaction (26, 36) électriquement conducteur qui interagit avec l'écran capacitif (12), un actionnement par pression étant réalisé de manière sensiblement parallèle à un axe de rotation (A) en direction de l'écran capacitif (12), une liaison électrique entre l'interface utilisateur (14) de l'écran capacitif (12) et un élément d'actionnement rotatif (24) du dispositif d'actionnement par pression et rotation (16) étant réalisée lors de l'actionnement du dispositif d'actionnement par pression et rotation (16), et la liaison électrique étant fournie par l'intermédiaire dudit au moins un élément d'interaction (26, 36) électriquement conducteur qui contacte l'interface utilisateur (14) lors de l'actionnement, **caractérisé en ce que** le dispositif d'actionnement par pression et rotation (16) est réalisé en forme d'anneau, le système de commande (10) de véhicule automobile étant réalisé de manière à détecter au moins un actionnement par pression du dispositif d'actionnement par pression et rotation (16) de manière capacitive au moyen de l'écran capacitif (12), et l'ensemble du dispositif d'actionnement par pression et rotation (16) étant latéralement immobile dans un plan défini par l'écran (12).

2. Système de commande capacitif (10) de véhicule automobile selon la revendication 1, **caractérisé en ce qu'**il est prévu une pluralité d'éléments d'interaction (26) au moyen desquels l'angle de rotation du dispositif d'actionnement par pression et rotation (16) peut être détecté, et/ou **en ce que** ledit au moins un élément d'interaction (26) comprend une pluralité de tronçons (28) qui sont aptes à être actionnés séparément les uns des autres et au moyen desquels il est possible de détecter l'angle de rotation du dispositif d'actionnement par pression et rotation (16), la pluralité de tronçons (38) comprenant en particulier chacun une structure de réponse haptique (55).

3. Système de commande capacitif (10) de véhicule automobile selon l'une des revendications précédentes, **caractérisé en ce que** le dispositif d'actionnement par pression et rotation (16) présente au moins un organe de transmission de force (40) qui coopère avec l'élément d'interaction (26).

4. Système de commande capacitif (10) de véhicule automobile selon l'une des revendications précédentes, **caractérisé en ce que** ledit au moins un élément d'interaction (26) est soumis à un changement de position relatif par rapport à l'interface utilisateur (14) de l'écran capacitif (12) lors de l'actionnement du dispositif d'actionnement par pression et rotation (16).

5. Système de commande capacitif (10) de véhicule automobile selon la revendication 4, **caractérisé en ce que** le changement de position relatif est effectué dans un plan perpendiculaire à l'interface utilisateur (14) de l'écran capacitif (12).

6. Système de commande capacitif (10) de véhicule automobile selon l'une des revendications précédentes, **caractérisé en ce que** ledit au moins un élément d'interaction (26) est formé par au moins un aimant (28).

7. Système de commande capacitif (10) de véhicule automobile selon l'une des revendications précédentes, **caractérisé en ce que** ledit au moins un élément d'interaction (26) est élastique, mécaniquement précontraint et/ou électro- magnétiquement précontraint.

8. Système de commande capacitif (10) de véhicule automobile selon l'une des revendications précédentes, **caractérisé en ce que** le système de commande (10) de véhicule automobile comprend un capteur rotatif (58) au moyen duquel l'angle de rotation du dispositif d'actionnement par pression et rotation (16) peut être détecté lors d'un actionnement par rotation.

9. Système de commande capacitif (10) de véhicule automobile selon la revendication 8, **caractérisé en ce que** le capteur rotatif (58) comprend un capteur optique (64), un capteur à effet Hall (72) et/ou une bobine inductive (74).

10. Système de commande capacitif (10) de véhicule automobile selon l'une des revendications précédentes, **caractérisé en ce que** l'écran capacitif (12) présente au moins une zone d'affichage (18) qui est associée au dispositif d'actionnement par pression et rotation (16) et qui sort une réponse optique lors de l'actionnement du dispositif d'actionnement par pression et rotation (16).

11. Système de commande capacitif (10) de véhicule automobile selon l'une des revendications précédentes, **caractérisé en ce que** le dispositif d'actionnement par pression et rotation (16) comprend une base stationnaire (22) et un élément d'actionnement (24) déplaçable par rapport à la base (22).
